Europäisches Patentamt

European Patent Office

Office européen des brevets

(19)

(11) Numéro de publication: **0 402 286**

**A1**

(12)

# DEMANDE DE BREVET EUROPEEN

(21) Numéro de dépôt: 90420271.0

(22) Date de dépôt: 05.06.90

(51) Int. Cl.5: **G01R 31/00, G01R 19/165**

(30) Priorité: **08.06.89 FR 8907830**

(43) Date de publication de la demande:
**12.12.90 Bulletin 90/50**

(84) Etats contractants désignés:
**BE CH DE ES GB IT LI**

(71) Demandeur: **ANNECY ELECTRONIQUE**
**ZA "Les Marais"**
**F-74410 Saint Jorioz(FR)**

(72) Inventeur: **Perrot, André**
**Immeuble "Les peupliers", Le brouillet**
**F-74320 Sevrier(FR)**
Inventeur: **Wintz, Bernard**
**Endrezon**
**F-74410 Saint Jorioz(FR)**
Inventeur: **Domenjoud, Jean François**
**Route de la Chapelle**
**F-74320 Sevrier(FR)**

(74) Mandataire: **Gasquet, Denis**
**9, rue Général Ferrié**
**F-74000 Annecy(FR)**

(54) **Procédé de contrôle de circuits électriques de véhicules par utilisation d'un shunt et dispositif de contrôle.**

(57) Procédé de contrôle de circuits électriques alimentés en courant continu, notamment de véhicules, caractérisé en ce qu'il consiste à utiliser un shunt, branché en série entre l'une des bornes de la batterie d'alimentation et le cable électrique de liaison normalement branché à cette borne.

FIG 5

EP 0 402 286 A1

La présente invention concerne un procédé destiné à contrôler les circuits électriques alimentés en courant continu comme par exemple ceux des véhicules automobiles. Elle concerne également les dispositifs destinés à mettre en oeuvre le procédé.

Les faisceaux électriques des véhicules automobiles, que ce soit pour des véhicules légers, des poids lourds, dès engins de chantier, militaires ou agricoles, sont de plus en plus denses et complexes, et la détection des défauts est rendue de ce fait de plus en plus difficile. D'autre part les, causes de panne sont de plus en plus fréquentes, car l'utilisiation des véhicules se fait dans des conditions de plus en plus sévères. En effet ceux-ci sont soumis à de dures contraintes d'environnement, telles que la chaleur, le froid, la corrosion, sans oublier les vibrations perpétuelles. le contrôle des circuits est donc un souci important des garagistes, et les électriciens spécialisés n'ont actuellement que la seule possibilité de faire des mesures de courants pour établir le diagnostic de certaines pannes. Le réparateur, actuellement utilise soit un ampéremètre soit un voltohmampèremètre, communément appelé "contrôleur universel". L'utilisation d'un tel appareil est très malaisée, et les risques de détérioration sont si élevés que le dépanneur s'abstient le plus souvent de l'utiliser et se prive ainsi d'un moyen de diagnostic essentiel. Un autre obstacle quant à l'utilisation des appareils traditionnels comme ceux évoqués précédemment est que les valeurs des courants à mesurer sont très variables. Ainsi l'utilisateur peut avoir à mesurer des courants de quelques dizaines de milliampères, ainsi que des courants pouvant atteindre plusieurs centaines d'ampères. En effet des fuites de courant de quelques dizaines de milliampères peuvent entrainer une décharge intempestive de la batterie, et le courant débité par le démarreur peut atteindre plusieurs centaines d'ampères. Aussi dans le cas de l'utilisation d'un ampèremètre traditionnel, le dépanneur est obligé de procéder à de nombreux changements de calibres sans pour autant connaitre préalablement l'ordre de grandeur de la valeur du courant à mesurer. Notons qu'un mauvais choix du calibre peut endommager l'appareil de mesure, ce qui ne manque pas d'arriver fréquemment.

La présente invention veut donc remédier à ces différents inconvénients en proposant un procédé particulièrement simple et fiable, et un dispositif destiné à mettre en oeuvre celui-ci.

Selon l'invention, le procédé de contrôle est caractérisé en ce qu'il consiste à utiliser un shunt, branché en serie entre l'une des bornes de la batterie d'alimentation et le cable électrique (11) de liaison normalement branché à cette borne. Le shunt est un shunt unique, de puissance suffisante pour pouvoir, sans échauffement excessif être traversé par les plus forts courants normalement mis en jeu dans les circuits de la batterie. Selon l'invention, on compare la tension issue du shunt, fonction du courant qui le traverse, à un certain nombre de tensions prédéterminées correspondant à des valeurs de courant prédéterminées et on signale si le courant mesuré est supérieur à l'une ou plusieures valeurs prédéterminées appplelées seuils. Ainsi les sorties de mesure du shunt sont appliquées aux entrées d'un microvoltmètre à polarité et changement de calibre automatique. Avantageusement la fonction de transfert du microvoltmètre est adaptée au shunt, de façon à traduire la mesure en indication ampèremètrique directe.

Avantageusement, la fonction de transfert du microvoltmètre est discontinue, et la courbe de transfert de l'indication par rapport à la mesure est une courbe en escaliers. Selon un mode préféré, on détermine la tension issue du shunt, que l'on amplifie, et l'on délivre une tension égale à la valeur absolue de cettedite tension amplifiée, que l'on compare à des seuils prédéterminés, pour signaler l'amplitude du courant réel passant dans le shunt. L'on signale donc si le courant mesuré est supérieur ou égal à l'une ou plusieurs valeurs prédéterminées, appelées seuils. Aussi on fait varier le gain de l'amplification de façon discontinue en fonction de l'amplitude du courant circulant dans le shunt.

Le shunt unique est branché entre la masse et la borne de la batterie normalement reliée à la masse, à savoir la borne négative de celle-ci dans la configuration la plus répandue.

Le procédé de contrôle selon l'invention est caractérisé en ce que l'on utilise un dispositif de contrôle comprenant un shunt, relié à un boitier de contrôle par un cordon de liaison et comprenant des moyens d'alimentation pour le shunt et les circuits du boitier.

Ledit procédé comprenant les étapes suivantes:
- on débranche de la borne négative de la batterie la liaison reliée à la masse.
- on connecte le shunt entre l'extrémité de cette liaison restée libre, et la borne négative de la batterie.
- on alimente le dispositif en courant continu, en le branchant à la deuxième borne de la batterie.
- on lit le résultat obtenu sur le boitier.

L'invention concerne aussi le dispositif de contrôle destiné à mettre en oeuvre le procédé et comprend un shunt, relié à un boitier de contrôle par un cordon de liaison et des moyens d'alimentation. Le shunt comprend deux prises de mesure, reliées à des moyens d'amplification. Le dispositif comprenant, par ailleurs, des moyens de commutation automatique de polarité, des moyens de commutation automatique de gain des moyens de comparaison entre le courant mesuré et des valeurs de courant prédéterminées, et des moyens de signalisation du résultat de la comparaison.

Selon une caractéristique complémentaire, le dispositif comprend des moyens de comparaison déterminant le sens du courant mesuré, et des moyens de signalisation du sens du courant.

Selon une autre caractéristique complémentaire, le dispositif de contrôle comprend des moyens de contrôle et de signalisation de la tension de la batterie et de son système de charge, ainsi que des moyens de protection contre les erreurs de branchement, et de visualisation desdites erreurs.

Le shunt utilisé est tel que sa valeur ohmique soit d'une part suffisamment élevée pour qu'il délivre, pour les faibles courants à mesurer (de l'ordre de la dizaine de milliampères) une tension de mesure suffisamment élevée pour pouvoir être traitée par un amplificateur de mesure à zéro automatique, également appelé amplificateur à "chopper", et soit d'autre part suffisamment faible pour que, soumis aux courants les plus forts (quelques centaines d'ampères) son échauffement reste raisonnable, sans qu'il soit nécessaire de lui donner des dimensions qui le rendraient trop encombrant pour l'usage auquel il est destiné.

Le shunt est avantageusement unique et sa résistance est de l'ordre du milliohm.

Le shunt est avantageusement connecté sur la borne négative de la batterie pour éviter sa détérioration en cas de court circuit à la masse, avec formation d'étincelles.

D'autres caractéristiques, et avantages de l'invention se dégageront de la description qui va suivre en regard des dessins annexés, qui ne sont donnés qu'à titre d'exemples non limitatifs.

La figure 1 est un schéma général représentant schématiquement le dispositif de contrôle.

La figure 2 représente schématiquement le véhicule avec ses circuits électriques à contrôler.

Les figures 3, 4 et 5 montrent les différentes étapes du contrôle.

La figure 6 est une représentation d'un circuit de contrôle du dispositif.

La figure 7 représente un circuit d'alimentation stabilisé pour le circuit de contrôle du dispositif.

La figure 8 représente un circuit de contrôle de l'état de la batterie et de son système de charge.

La figure 9 représente une variante.

La figure 10 représente un exemple de réalisation des moyens de mémorisation des maxima.

La figure 11 représente un circuit de protection contre les erreurs de branchement, et de visualisation desdites erreurs.

La figure 12 représente une variante de réalisation.

Les figures 13 et 14 montrent une autre variante d'un shunt, la figure 13 montrant le shunt en vue latérale, et la figure 14 le représentant selon une vue de dessus.

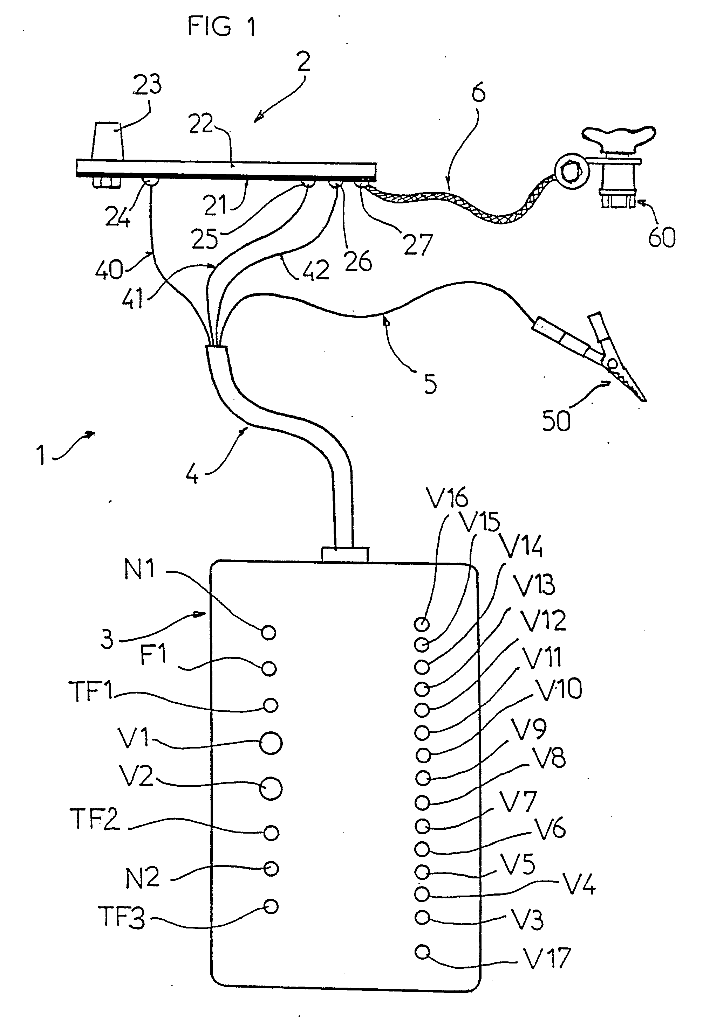

La figure 1 représente le dispositif de contrôle (1) destiné à mettre en oeuvre le procédé selon l'invention. ce dispositif comprend un shunt référencé globalement par la référence (2) relié à un boitier de contrôle (3) par un cordon de liaison (4). Il comprend par ailleurs des moyens d'alimentation (5, 6, 23). Le shunt unique est constitué par une feuille de métal (21) fixée sur un support isolant (22). et sa résistance peut être de l'ordre d'un milliohm. Il comporte à l'une de ses extrémités une borne de connexion (23), et à l'autre extrémité un cable de liaison (6) de forte section et portant un dispositif de connexion (60) adapté au raccordement à la batterie. Notons que la borne de connexion (23) a la même géométrie que la borne de la batterie du véhicule. Ledit shunt (2) comporte en outre plusieurs dispositifs de connexion (24,25,26,27). Les deux connexions (24,25) servant de prise de mesure sont raccordés aux conducteurs de prise de mesure (40,41), la connexion (26) étant destinée au conducteur d'alimentation négative (42). Le cable de liaison (6) est relié à la connexion (27). Le cable d'alimentation (5) est par ailleurs terminé par des moyens de branchement constitués par exemple par un pince de branchement (50). Le cordon de liaison (4) constitué des quatre conducteurs (40,41,42,5) relie le boitier de contrôle (3) d'une part au shunt (2) et d'autre part à la batterie d'alimentation. Le boitier (3) comprend différents circuits électroniques et des voyants de visualisation.

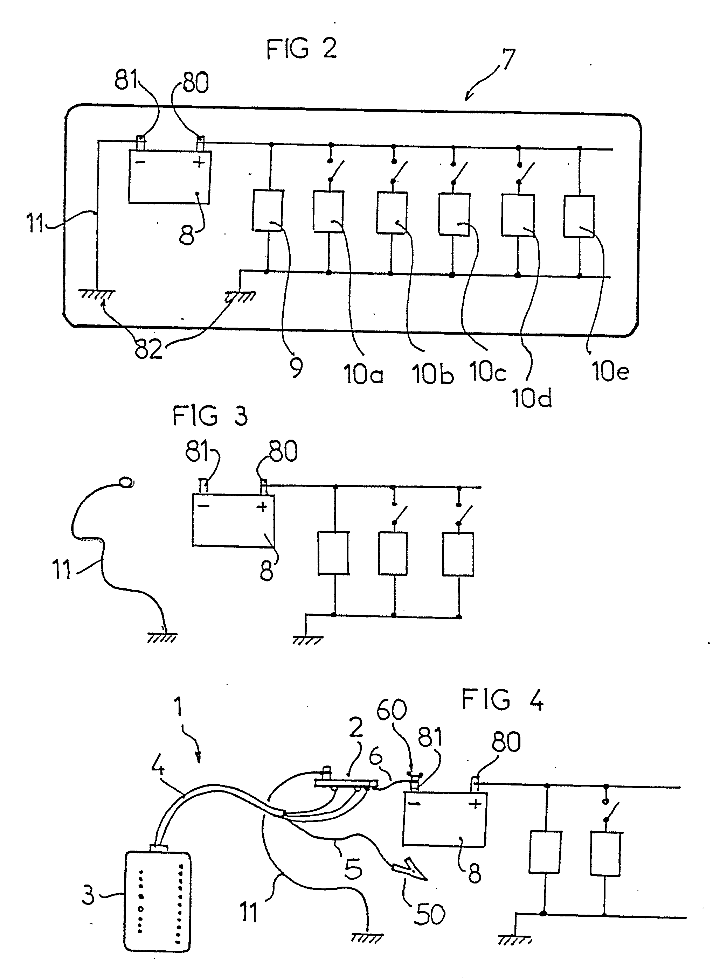

La figure 2 représente schématiquement le véhicule automobile (7) dont les circuits électriques sont à contrôler, et qui comprend de façon connue en soit une batterie électrique ou accumulateur (8) reliée d'une part au dispositif de charge (9) et d'autre part aux différents consommateurs électriques, soit intermitents, tels que lampes (10a), moteurs électriques (10b), démarreur (10c), allumeur (10d), etc, mis en service par des interrupteurs, soit permanents tels qu'horloge de bord ou dispositif antivol (10e). Ces différents équipements sont branchés d'une part à la borne ou cosse positive (80) de la batterie (8) et d'autre part à la borne ou cosse négative (81) par l'intermédiaire de la masse (82).

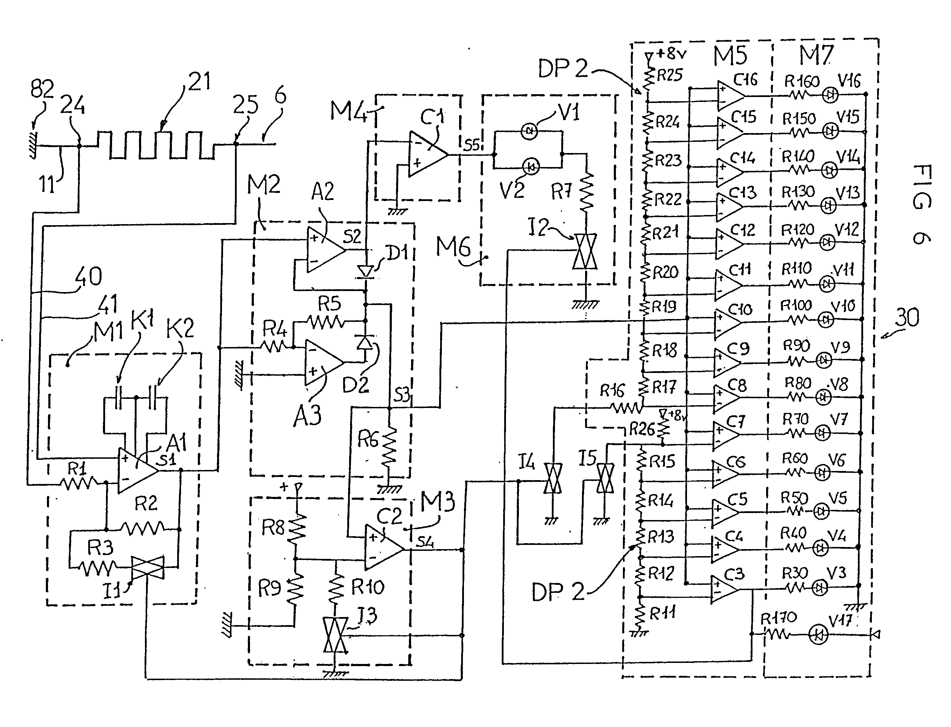

La figure 6 représente un mode de réalisation d'un circuit de contrôle (30). Ce circuit comprend des moyens d'amplification (M1), des moyens de commutation automatique de polarité (M2), des moyens de commutation automatique de gain (M3), des moyens de comparaison (M4) et (M5), ainsi que des moyens de signalisation (M6) et (M7). les moyens d'amplification microvoltmétrique (M1) sont destinés à amplifier la tension de mesure issue du shunt (2) à travers les liaisons (40) et (41). Les moyens de commutation automatique de polarité (M2) sont destinés à délivrer une tension égale à la valeur absolue de la tension issue des moyens d'amplification (M1), ainsi qu'une tension significative du sens du courant dans le shunt (2). Les moyens de commutation automatique de gain (M3) sont destinés à modifier de façon discontinue le gain des moyens d'amplification (M1) en fonction de l'amplitude du courant circulant dans le shunt (2). Les premiers moyens de comparaison (M4) déterminent le sens du courant dans le shunt (2) et les moyens de signalisation correspondants (M6) mettent en évidence s'il sagit d'un courant de charge ou de décharge de la batterie (8). Les seconds moyens de comparaison portant la référence (MS) comparent l'amplitude du courant dans le shunt à des seuils de courant prédéterminés et des moyens de signalisation (M7) mettent en évidence de façon visuelle l'amplitude du courant traversant ledit shunt (2).

Le procédé de contrôle représenté partiellement aux figures 3, 4, et 5 comprend les différentes phases suivantes:

a-on débranche le cable de liaison (11) de la cosse négative (81) de la batterie (8), (figure 3).

b-on relit le dispositif de connexion (60) du shunt à la cosse négative (81) de la batterie (8), et le cable de liaison (11) à la connexion (23) du shunt (2), (figure 4).

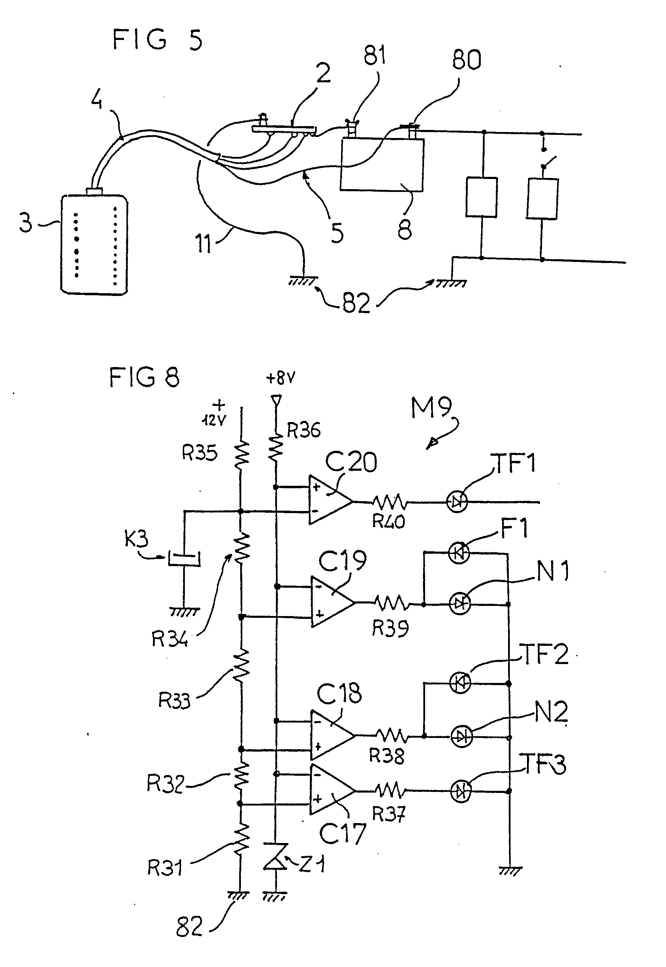

c-on relie la connexion (50) du conducteur (5) à la cosse positive (80) de la batterie, (figure 5).

d-on lie les résultats de la mesure grâce aux voyants du boitier.

Bien entendu les opérations b et c peuvent être inversées

La figure 6 représente un exemple de réalisation d'un circuit de contrôle (30), comprenant des moyens d'amplification (M1) constitués par un circuit d'amplification, des moyens de commutation automatique de polarité (M2) constitués par un circuit de commutation, des moyens de commutation automatique de gain (M3) constitués par un circuit de commutation automatique de gain, des moyens de comparaison (M6) et (M7) constitués par des circuits de comparaison, et des moyens de signalisation ou de visualisation (M6) et (M7) constitués par des circuits de visualisation.

Pour la clareté des schémas, et comme il est d'usage, notons que les différentes alimentations des composants n'ont pas été représentées. L'alimentation des composants étant faite à partir de la batterie du véhicule. A partir du schéma fonctionnel, donné à titre d'exemple, il est bien entendu possible d'aboutir au même fonctionnement avec une autre réalisation.

Les moyens d'amplification (M1) sont constitués par un amplificateur (A1) deux condensateurs (K1) et (K2), trois résistances (R1), (R2) et (R3) et un interrupteur analogique (I1). La prise de mesure (41) du shunt (2) est relié é l'entrée positive ( + ) de l'amplificateur (A1) à remise à zéro. La prise de mesure (40) est quant à elle reliée d'une part à la masse, et d'autre part à l'entrée négative (-) de l'amplificateur (A1) par l'intermédiaire d'une résistance (R1). Par ailleurs, l'entrée négative (-) est reliée à la sortie (S1) de l'amplificateur (A1) par l'intermédiaire d'une part d'une résistance (R2), et d'autre part par une résistance (R3) en série avec un interrupteur analogique (11). Comme on peut le voir sur la figure la résistance (R2) est en parallèle avec les deux éléments montés en série (R3, I1). La chaine d'amplification ainsi réalisée présente un gain G1 lorsque l'interrupteur analogique (I1) est ouvert, et un gain G2 lorsqu'il est fermé. Les condensateur (K1) et (K2) sont des condensateurs de correction automatique de zéro.

Les moyens de commutation automatique de polarité (M2) sont constitués par deux amplificateurs (A2) et (A3), trois résistances (R4), (R5) et (R6) et deux diodes (D1) et (D2). La sortie (S1) de l'amplificateur (A1) est reliée à l'entrée positive ( + ) de l'amplificateur (A2) et à l'entrée négative (-) de l'amplificateur (A3) au travers de la résistance R4). La sortie (S2) de l'amplificateur (A2) est reliée à l'anode d'une diode (D1) dont la cathode est reliée à son entrée négative (-). D'autre part la sortie de l'amplificateur (A3) est reliée à l'anode d'une diode (D2) dont la cathode est reliée à la résistance (R5) reliée par son autre extrémité à l'entrée négative de l'amplificateur (A3). Les cathodes des diodes (D1) et (D2) sont reliées entre elles au point (S3) ainsi qu'à la masse par l'intermédiaire de la résistance (R6). On obtient ainsi au point (S3) la valeur absolue de la tension de la sortie (S1) de l'amplificateur (A1).

Les moyens de détection du sens du courant (M4) sont constitués par un comparateur (C1), et les moyens de visualisation (M6) de deux diodes électroluminescentes (V1) et (V2), d'une résistance (R7) et d'un interrupteur analogique (I2). La sortie (S2) de l'amplificateur (A2) est appliquée à l'entrée négative (-) d'un comparateur (C1), dont l'entrée positive ( + ) est reliée à la masse. La sortie (S5) dudit comparateur est reliée à l'anode de la diode electroluminescente (V1), et à la cathode de la diode électroluminescente (V2). La cathode de la diode (V1) et l'anode de la diode (V2) sont reliées entre elles, ainsi qu'à la résistance (R7), elle même reliée à la masse par l'intermédiaire de l'interrupteur analogique (I2). Ainsi quand l'interrupteur analogique (I2) est fermé la diode (V1) s'éclaire en présence d'un courant de charge de la batterie, et la diode (V2) s'éclaire pour un courant de décharge. Lorsque l'interrupteur analogique (I2) est ouvert, les deux diodes électroluminescentes (V1) et (V2) restent éteintes.

Les moyens de commutation automatique du gain ou du calibre sont constituées par un circuit comprenant le comparateur (C2), les résistances (R8), (R9) et (R10) ainsi que l'interrupteur analogique (I3). La sortie (S3) des moyens (M2) est reliée à l'entrée positive (+) du comparateur (C2), dont l'entrée négative (-) est reliée à la tension positive d'alimentation à travers la résistance (R8), et à la masse par la résistance (R9). L'entrée négative du comparateur (C2) est par ailleurs reliée à la masse par l'intermédiaire de la résistance (R10) montée en série avec l'interrupteur analogique (I3). Celui-ci étant commandé par la sortie (S4) qui commande aussi l'interrupteur analogique (I1), pour agir sur le gain de l'amplificateur (A1). Notons aussi que la sortie (S4) commande aussi les deux interrupteur anlogiques (I4) et (I5), dont les fonctions seront décrites ultérieurement.

L'ensemble des amplificateurs (A1), (A2), (A3), les comparateurs (C1), (C2) et les éléments qui y sont associés constituent un amplificateur de mesure microvolmétrique à commutations automatiques de polarité et de calibre.

Le shunt (21) peut avantageusement présenter un résistance de 1 milliohm et délivre ainsi une tension de 1 millivolt par ampère. Les valeurs des résistances (R1), (R2), (R3) peuvent avoir des valeurs telles que le gain de l'amplificateur (A1) bouclé soit de G1 égal à 1000, lorsque l'interrupteur (I1) est ouvert, et de G2 égal à 10 lorsque celui-ci est fermé. Les amplificateurs (A2) et (A3) associés aux diodes (D1) et (D2) et aux résistances (R4), (R5) et (R6) constituent un amplificateur redresseur, qui délivre à la sortie (S3) une tension toujours positive, valeur absolue de la tension obtenue à la sortie (S1). On obtient ainsi à la sortie (S3) une tension positive de plus ou moins 1 volt par ampère, lorsque l'interrupteur (I1) est ouvert, et une tension positive de plus ou moins 10 millivolts par ampère quand l'interrupteur (I1) est fermée.

Les résistances (R8), (R9), et (R10) peuvent avantageusement avoir des valeurs telles que la tension appliquée à l'entrée négative (-) du comparateur (C2) soit de 5 volts lorsque l'interrupteur analogique (I3) est ouvert, et de 30 millivolts quand il est fermé. Ainsi lorsque l'on fait parcourir le shunt (21) par un courant croissant, de polarité quelconque, la sortie (S4) du comparateur (C2)sera au niveau bas et commandera l'ouverture des interrupteurs analogiques (I1), (I3), (I4) et (I5). On aura ainsi à l'entrée positive du comparateur (C2) une tension de 1 volt par ampère et une tension de 5 volts sur l'entrée négative. Lorsque le courant appliqué au shunt (21) atteindra 5 ampères, la sortie (S4) du comparateur (C2) basculera au niveau haut, et commandera la fermeture des interrupteurs (I1), (I3), (I4) et (I5). La tension en (S3) passera alors de 5 volts à 50 millivolts, et la tension sur l'entrée négative du comparateur (C2) passera de 5 volts à 30 millivolts. La sortie (S4) du comparateur (C2) restant donc au niveau haut. Si on continue de faire croître le courant dans le shunt, la sortie (S4) reste dans son état précédent, et on pourra faire croître le courant jusqu'à 500 ampères pour obtenir à nouveau 5 volts sur la sortie (S3). Si maintenant on fait décroître le courant, la sortie (S4) restera en l'état jusqu'à ce que la tension en (S3) chute à 30 millivolts, ce qui correspond à un courant de 3 ampères dans le shunt. La sortie (S4) du comparateur (C2) basculera alors au niveau bas, et l'on se retrouvera dans les conditions initiales.

Le circuit comprend par ailleurs des moyens de comparaison (M5) constitués par une suite de comparateurs dont chacune des entrées négatives est reliée aux sorties respectives d'un premier diviseur potentiométrique (DP1) constitué par les résistances (R11), (R12), (R13), (R14), (R15) et (R26), en ce qui concerne les comparateurs (C3), (C4), (C5), (C6) et (C7), et aux sorties respectives d'un deuxième diviseur potentiométrique (DP2) constitué par les résistances (R16), (R17), (R18), (R19), (R20), (R21), (R22), (R23), (R24) et (R25) en ce qui concerne les comparateurs (C8), (C9), (C10), (C11), (C12), (C13), (C14), (C15) et (C16). Lorsque les interrupteurs analogiques (I4) et (I5) sont ouverts, le diviseur potentiométrique (DP1) alimenté entre la masse et la tension stabilisée (+8 volts), délivre cinq tensions de seuil aux comparateurs (C3) à (C7). Le diviseur potentiométrique (DP2) n'est alimenté que d'un coté et délivre la tension stabilisée (+8 volts) sur toutes les sorties. Lorsque les interrupteurs analogiques (I4) et (I5) sont fermés, le diviseur potentiométrique (DP1) est relié à la masse aux deux extrémités et délivre une tension nulle sur toutes ses sorties. Le diviseur potensiométrique (DP2) est alimenté entre la tension stabilisée (+8 volts) et la masse, et délivre neuf tensions de seuil aux comparateurs (C8) à (C16). Notons que le point (S3) est relié aux entrées positives (+) des différents comparateurs (C3), (C4), (C5), (C6), (C7), (C8), (C9), (C10), (C11), (C12), (C13), (C14), (C15), et (C16). Les moyens de signalisation (M7) sont constitués par une série de diodes électroluminescentes (V3), (V4), (V5), (V6), (V7), (V8), (C9), (V10), (V11), (V12), (V13), (V14), (V15), et (V16). Les sorties des comparateurs (C3), (C4), (C5), (C6), (C7), (C8), (C9), (C10), (C11), (C12), (C13), (C14), (C15), et (C16) activent chacune les diodes électroluminescentes correspondantes (V3), (V4), (V5), (V6), (V7), (V8), (V9), (V10), (V11), (V12), (V13), (V14), (V15), et (V16) à travers les résistances (R30), (R40), (R50), (R60), (R70), (R80), (R90), (R100), (R110), (R120), (R130), (R140), (R150), et (R160), comme cela est représente à la figure 6. Notons aussi que les cathodes des diodes électroluminescentes sont reliées à la masse. Ainsi seront allumées toutes les diodes électroluminescentes activées par les comparateurs dont la tension de seuil est inférieure à la tension trouvée au point (S3). L'entrée négative du comparateur (C7) est reliée à l'interrupteur analogique (I5) et aux deux résistances (R15) et (R26). Ladite résistance (R26) étant reliée au potentiel d'alimentation positive de 8 volts. Notons aussi que l'entrée négative du comparateur (C8) est reliée à la résistance (R16 montée en série avec l'interrupteur analogique (I4).

Lorsque la sortie (S4) est au niveau bas, les interrupteurs analogiques (I4) et (I5) sont ouverts. Les entrées négatives (-) des comparateurs (C8), (C9), (C10), (C11), (C12), (C13), (C14), (C15), et (C16) sont alors reliés à travers les résistances (R16), (R17), (R18), (R19), (R20), (R21), (R22), (R23), (R24), (R25) à l'alimentation positive( +8 volts), et les sorties des comparateurs sont au niveau bas et les diodes électroluminescentes correspondantes éteintes. Les entrées négatives (-) des comparateurs (C3), (C4), (C5), (C6), (C7) sont respectivement reliés aux différents potentiels prédéterminés apparaissant le long de la chaîne de résistances (R11), (R12), (R13), (R14), (R15) reliée au potentiel d'alimentation positive ( + 8 volts) à travers la résistance (R26). Selon la grandeur de la tension en (S3), les comparateurs délivrent des niveaux hauts ou bas, et excitent ou non les diodes électroluminescentes correspondantes. Lorsque la sortie (S4) est au niveau haut, les interrupteurs analogiques (I4) et (I5) sont fermés. Les entrées négatives (-) des comparateurs (C3), (C4), (C5), (C6), (C7) sont alors reliées à la masse, à travers la chaine de résistances (R11), (R12), (R13), (R14), (R15). Les comparateurs délivrent des niveaux hauts qui excitent les diodes électroluminescentes (V3), (V4), (V5), (V6), (V7). Le pied de la résistance (R16) est relié à la masse par l'interrupteur analogique (I4). Les entrées négatives des comparateurs (C8), (C9), (C10), (C11), (C12), (C13), (C14), (C15), et (C16), sont reliées respectivement aux différents potentiels prédéterminés apparaissant le long de la chaîne de résistances (R16), (R17), (R18), (R19), (R20), (R21), (R22), (R23), (R24), (R25). Selon la grandeur de la tension en (S3), les comparateurs délivrent des niveaux hauts ou bas, et excitent ou non les diodes électroluminescentes correspondantes

On obtient ainsi la visualisation de la grandeur du courant circulant dans le shunt par valeurs inférieures.

La sortie du comparateur (C3) active à travers une résistance (170) une autre diode électroluminescente (V17) dont l'anode est reliée à la tension positive d'alimentation. La diode électroluminescente (V17) s'allumera donc lorsque le courant sera inférieur au premier seuil, c'est-à-dire lorsque toutes les autres diodes (V3), (V4), (V5), (V6), (V7), (V8), (C9), (V10), (V11), (V12), (V13), (V14), (V15), et (V16) seront éteintes. La sortie du comparateur (C3) commandant par ailleurs l'interrupteur analogique (I2) qu'il ouvre lorsque la sortie du comparateur (C3) est au niveau bas, de façon à éteindre les diodes électroluminescentes (V1) et (V2).

Selon le mode préféré la diode électroluminescente (V3) indiquera qu'un courant supérieur ou égal à 0,03 ampère traverse le shunt, la diode électroluminescente (V4) indiquera qu'un courant supérieur ou égal à 0,1 ampère traverse le shunt, la diode électroluminescente (V5) indiquera qu'un courant supérieur ou égal à 0,3 ampère traverse le shunt, la diode électroluminescente (V6) indiquera qu'un courant supérieur ou égal à 1 ampère traverse le shunt la diode électroluminescente (V7) indiquera qu'un courant supérieur ou égal à 3 ampères traverse le shunt, la diode électroluminescente (V8) indiquera qu'un courant supérieur ou égal à 10 ampères traverse le shunt, la diode électroluminescente (V9) indiquera qu'un courant supérieur ou égal à 20 ampères traverse le shunt, la diode électroluminescente (V10) indiquera qu'un courant supérieur ou égal à 30 ampères traverse le shunt, la diode électroluminescente (V11) indiquera qu'un courant supérieur ou égal à 50 ampères traverse le shunt, la diode électroluminescente (V12) indiquera qu'un courant supérieur ou égal à 75 ampères traverse le shunt, la diode électroluminescente (V13) indiquera qu'un courant supérieur ou égal à 100 ampères traverse le shunt, la diode électroluminescente (V14) indiquera qu'un courant supérieur ou égal à 150 ampères traverse le shunt, la diode électroluminescente (V15)indiquera qu'un courant supérieur ou égal à 200 ampères traverse le shunt, et la diode électroluminescente (V16) indiquera qu'un courant supérieur ou égal à 250 ampères traverse le shunt. La diode électroliminescente (V17) indiquant qu'un courant inférieur ou égal à 0,03 ampère traverse le shunt.

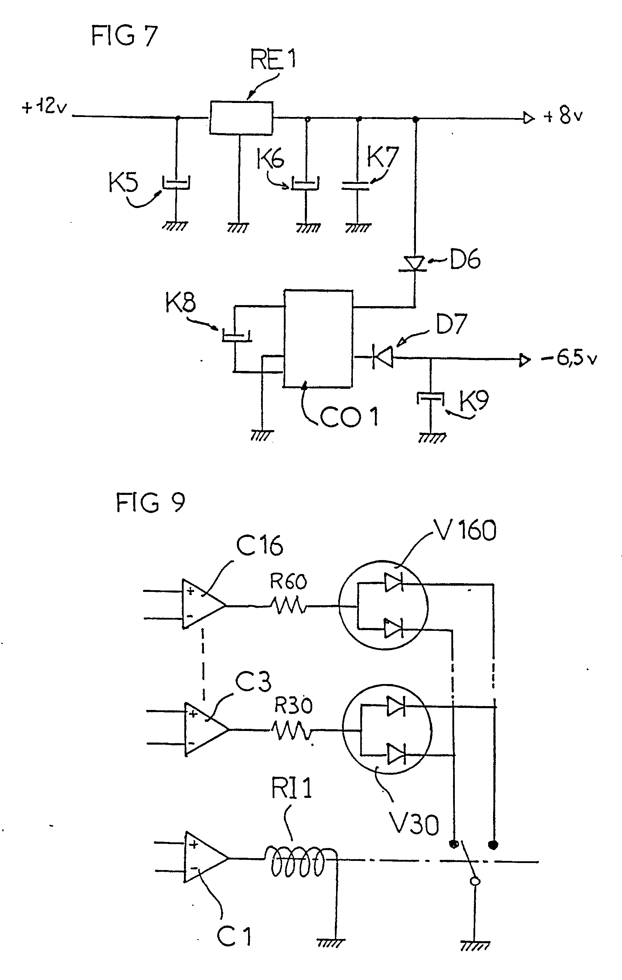

On peut avantageusement remplacer les diodes électroluminescentes (V3) à (V16) par des diodes électroluminescentes bicolores (V30) à (V160) comme cela est représenté à la figure 9. Pour cela on commute la couleur selon qu'il s'agit d'un courant de charge ou de décharge. Dans ce mode de réalisation, les diodes électroluminescentes (V1) et (V2), la résistance (R7) et l'interrupteur analogique (I2) sont supprimés et remplacés par un élément de commutation qui relie à la masse l'une ou l'autre terminaison de la diode électroluminescente, permettant de sélectionner la couleur. La couleur correspondant à un courant de charge pourra avantageusement être verte, celle correspondant à un courant de décharge rouge. la figure 9 montre un mode de réalisation, selon lequel il est fait usage d'un relai inverseur (RI1) commandé par la sortie du comparateur (C1).

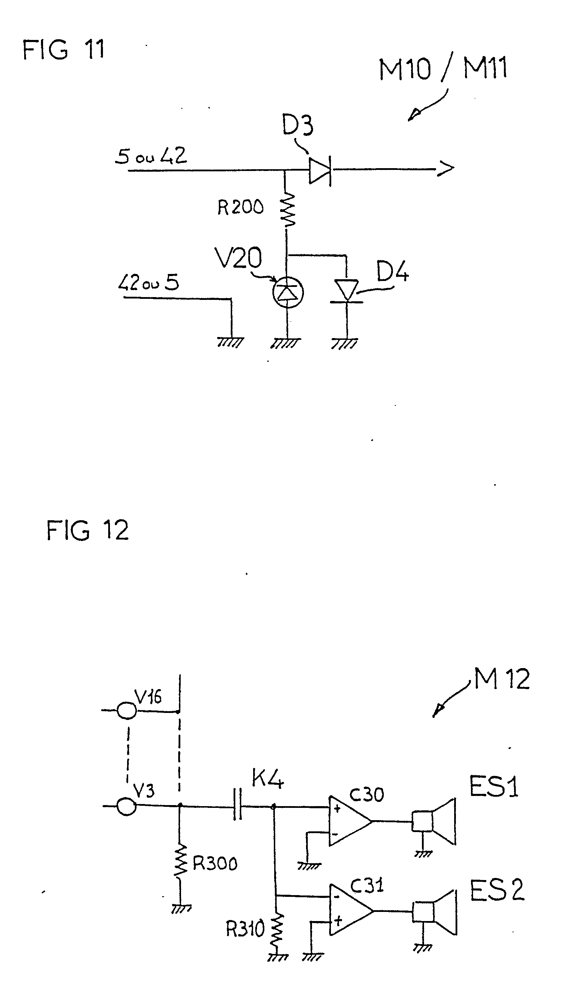

La figure 10 représente un mode de réalisation de moyens de mémorisation (M8) pour mémoriser des maxima. On insère entre les sorties de chaque comparateur (C3) à (C16) et les résistances en série (R30) à (R160) des circuits (F3) à (F16) à fonction logique, tous identiques constitués d'une bascule bistable (B1), d'une porte "ET" (P1), et d'une porte "OU" (P2). Lorsque l'entrée (R) de la bascule (B1) est reliée au niveau logique "1", sa sortie (Q) est au niveau "0", quelque soit le niveau de l'entrée (S). Lorsque l'entrée (R) de la bascule (B1) est au niveau "0", sa sortie (Q) passe au niveau "1" lorsque l'entrée (S) passe au niveau "1", et y reste, quelque soit le niveau de l'entrée (S), jusqu'à ce que l'entrée (R) repasse au niveau "1". La sortie du comparateur (C3) à (C16) est reliée d'une part à l'entrée (S) de la bascule (B1), et d'autre part à la porte "OU" (P2). L'entrée de ladite bascule (B1) étant reliée à un inverseur (IN1) qui permet de la relier soit au niveau "0", c'est-à-dire à la masse, soit au niveau "1", c'est-à-dire au potentiel positif d'alimentation. la sortie (Q) de la bascule (B1) est reliée à l'entrée de la porte "ET" (P1), qui reçoit sur l'autre entrée un signal carré très basse fréquence, délivré par un oscillateur (O1). La sortie de la porte "ET" (P1) est reliée à la deuxième entrée de la porte "OU" (P2). Si l'inverseur IN1) délivre un signal "1", la sortie (Q) de la bascule (B1) est au niveau "0", donc la sortie de la porte " ou" (P1) est au niveau "0", et la porte (P2) délivre alors un signal "1" ou un signal "0", selon que le comparateur correspondant délivre un signal "0" ou "1". Le circuit logique (F3) à (F16) transmet alors simplement le signal issu du comparateur (C3) à (C16).

Si l'inverseur (IN1) délivre un signal "0", si la sortie du comparateur (C3) à (C16) est à "0", la sortie (Q) de la bascule (B1) reste à "0", et la diode correspondante reste éteinte. Par contre si la sortie du comparateur passe au niveau "1", la sortie de la porte (P2) passe au niveau "1", quelque soit le signal issu de (P1), et la diode correspondante est allumée. Par ailleurs, la sortie (Q) de la bascule (B1) aura basculé au niveau "1" et la porte (P1) délivrera le signal issu de l'oscillateur. Si la sortie du comparateur (C3) à (C16) rebascule au niveau "0", la porte (P2) recevra sur la première entrée un niveau "0" et sur l'autre le signal de l'oscillateur. Elle délivrera donc le signal de l'oscillateur et la diode clignotera pour signifier que l'amplitude de courant correspondante a été atteinte au moins une fois, l'amplitude présente du courant étant signalée par les diodes allumées mais non clignotantes. On obtient ainsi la mémorisation des maximas de courant. En insérant entre la sortie du comparateur (C3) à (C16) et l'entrée (S) de la bascule (B1) un inverseur logique, et en remplaçant la porte "ou" (P2) par une porte "ET", on obtient de même une mémorisation des minima de courant.

La figure 7 représente des moyens d'alimentation stabilisée (M10) qui comportent une alimentation régulée positive de plus 8 volts, constituée d'une alimentation tripolaire intégrée (RE1) associée aux condensateurs de filtrage (K5, K6, K7), et une alimentation négative de moins 6,5 volts, constituée d'un convertisseur de tension intégré (CO1), des diodes (D6, D7) et des condensateurs (K8, K9).

La figure 8 représente un mode de réalisation de moyens de contrôle et de signalisation (M9) de la batterie et de son système de charge. Ces moyens comprennent quatres comparateurs (C17), (C18), (C19) et (C20, six diodes électroluminescentes (TF1), (F1), (N1), (TF2), (N2) et (TF2), un condensateur polarisé (K3), six résistances (R31), (R32), (R33), (R34), (R35), (R36), (R37), (R38), (R39), (R40) et une diode zener (Z1). Les diodes électroluminescentes indiquant un fonctionnemnet normal de la batterie et de son système de charge seront avantageusement de couleur verte, celles indiquant un fonctionnement défectueux seront de couleur rouge. Selon le mode de réalisation représenté la diode (TF1) indiquera une batterie trop faible, la diode (F1) indiquant une batterie faible, tandis-que la diode (N1) indiquera une batterie normale. La diode (TF2) indiquant une charge trop faible, la diode (N2) une charge normale, et la diode (TF3) une charge trop forte. La chaine des résistances (R31) à (R35) étant reliée d'une part à la tension positive de la batterie, et d'autre part à la masse (82), tandis-que la résistance (R36) est reliée à l'alimentation positive stabilisée et à la masse par l'intermédiaire d'une diode zéner (Z1).

La figure 11 représente un exemple de réalisation des moyens de protection contre les erreurs de branchement (M10) et des moyens de signalisation de ces erreurs (M11). Lorsque la bonne polarité est appliquée à l'anode de la diode (D3), celle-ci est conductrice et délivre la tension d'alimentation aux circuits du boitier (3). Si la mauvaise polarité est appliquée, la diode (D3) est bloquée et la diode électroliminescente (V20) alimentée à travers la résistance (R200) s'allume.

la figure 12 représente un exemple schématique de réalisation des moyens de signalisation sonore (M12). On insère entre le point commun des diodes électroluminescentes (V3) à (V16) et la masse une résistance de faible valeur (R300). La tension apparaissant sur la résistance (R300) est appliquée, à travers un circuit dérivateur constitué par le condensateur (K4) et de la résistance (R310) à l'entrée positive du comparateur (C30), et à l'entrée négative du comparateur (C31), qui excitent respectivement des émetteurs sonores (ES1) et (ES2), qui sont avantageusement de tonalité différente. EN cas d'échelon de tension positif sur la résistance (R300), l'émetteur (ES1) est alimenté. En cas d'échelon de tension négatif, l'émetteur (ES2) est à son tour excité.

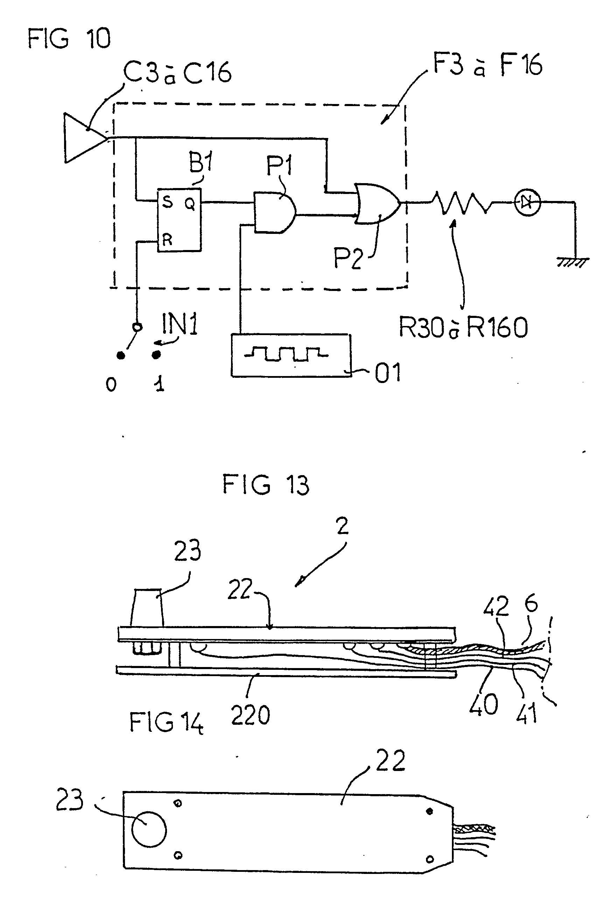

Le shunt (2) peut avantageusement être protégé, comme selon les figures 13 et 14. En effet selon cette variante, la partie résistive de celui-ci est protégée par une plaque protectrice (220), isolée de celle-ci et fixée au support isolant (22).

Bien entendu, l'invention n'est pas limitée aux modes de réalisation décrits et représentés à titre d'exemples, mais elle comprend aussi tous les équivalents techniques ainsi que leurs combinaisons.

## Revendications

1) Procédé de contrôle de circuits électriques alimentés en courant continu, notamment de véhicules (7), consistant à utiliser un shunt (21), branché en série entre l'une des bornes (81) de la batterie d'alimentation (8) et le cable électrique (11) de liaison normalement branche à cette borne, caractérisé en ce que l'on compare la tension issue du shunt, fonction du courant qui le traverse, à un certain nombre de tensions prédéterminées correspondant à des valeurs de courant prédéterminées et on signale si le courant mesuré est supérieur à l'une ou plusieurs valeurs prédéterminées appelées seuils.

2) Procédé de contrôle selon la revendication 1, caractérisé en ce que l'on détermine la tension issue du shunt (21), que l'on amplifiée, et l'on délivre une tension égale à la valeur absolue de cettedite tension amplifiée, que l'on compare à des seuils prédéterminés, pour signaler l'amplitude du courant réel passant dans le shunt (21).

3) Procédé de contrôle selon la revendication 2, caractérisé en ce que l'on fait varier le gain de l'amplification de façon discontinue en fonction de l'amplitude du courant circulant dans le shunt.

4) Procédé de contrôle selon l'une quelconque des revendications précédentes, caractérisé en ce que l'on utilise un dispositif de contrôle (1) comprenant un shunt (2), relié à un boitier de contrôle (3) par des prises de mesure ou conducteurs (40,41), et qui comprend par ailleurs des moyens d'alimentation (23, 6, 60, 5, 50) pour alimenter en courant ledit shunt ainsi que les circuits électroniques et composants du boitier (3) et que le procédé comprend les différentes étapes suivantes:
- on débranche de la borne négative (81) de la batterie (8) la liaison (11) reliée à la masse.

- on connecte le shunt entre l'extrémité de cette liaison (11) restée libre, et la borne négative (81) de la batterie (8).
- on alimente le dispositif en courant continu, en le branchant aux deux bornes (81, 80) de la batterie (8).
- on lit le résultat obtenu sur le boitier.

5) Dispositif de contrôle destiné à mettre en oeuvre le procédé selon l'une quelconque des revendications précédentes, comprenant un shunt (2), relié à un boitier de contrôle (3) par des prises de mesure ou conducteurs (40,41), et comprenant par ailleurs des moyens d'alimentation (23, 6, 60, 5, 50) pour alimenter en courant ledit shunt ainsi que les circuits électroniques et composants du boitier (3), caractérisé en ce que le shunt est unique, et que le boitier de contrôle comprend des moyens d'amplification (M1), des moyens de commutation automatique de polarité (M2), des moyens de commutation automatique de gain (M3), des moyens de comparaison (M5) entre le courant mesuré et des valeurs de courant prédéterminées, et des moyens de signalisation (M7) du résultat de la comparaison.

6) Dispositif de contrôle selon la revendication 5, caractérisé en ce qu'il comprend des moyens de comparaison (M4) déterminant le sens du courant mesuré, et des moyens de signalisation (M6) du sens du courant.

7) Dispositif de contrôle selon la revendication 6 caractérisé en ce qu'il comprend des moyens de contrôle et de signalisation (M9) de la tension de la batterie et de son système de charge.

8) Dispositif de contrôle selon l'une quelconque des revendications précédentes, caractérisé en ce qu'il comprend des moyens (M10), M11) de protection contre les erreurs de branchement, et de visualisation desdites erreurs.

9) Dispositif de contrôle selon l'une quelconque des revendications précédentes, caractérisé en ce qu'il comprend des moyens (M13) pour alimenter à partir de la batterie de l'installation à contrôler, les différents circuits et composants en tension stabilisée positive et négative.

10) Dispositif de contrôle selon l'une quelconque des revendications précédentes, caractérisé en ce que le shunt (2) est constitué par une feuille de métal (21) fixée sur un support isolant (22), et comprend deux connexions (24, 25) reliées par deux conducteurs de prise de mesure (40, 41) reliés aux moyens d'amplification (M1).

11) Dispositif de contrôle selon la revendication 10, caractérisé en ce que les moyens d'amplification (M1) envoient un signal (S1) aux moyens de commutation automatique de polarité (M2),qui envoient un signal (S3) d'une part aux moyens de comparaison (M5) et d'autre part aux moyens de commutation automatique de gain (M3), lesdits moyens de commutation automatique de gain (M3) étant reliés aux moyens d'amplification, ainsi qu'aux moyens de comparaison (M5).

FIG 1

FIG 2

FIG 3

FIG 4

FIG 5

FIG 8

FIG 6

EP 0 402 286 A1

FIG 7

RE 1

+12v ——————— +8v

K5    K6    K7

D6

K8    CO 1    D7    —6,5v

K9

FIG 9

C16    V160

R60

C3    R30

RI 1    V30

C1

FIG 11

M10 / M11

FIG 12

M 12

FIG 10

C3 à C16

F3 à F16

B1

S Q

R

P1

P2

IN1

0     1

01

R30 à R160

FIG 13

23

2

22

42  6

40  41

FIG 14

220

23

22

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 011 359  (AMERICAN GAGE & MACHINE CO.) * Page 1, lignes 17-24; page 4, ligne 17 - page 5, ligne 23; figure 1 * | 1-6 | G 01 R  31/00 G 01 R  19/165 |
| Y | DE-C-3 125 552  (SIEMENS) * Colonne 10, ligne 64 - colonne 11, ligne 11; colonne 11, ligne 59 - colonne 12, ligne 56; figure 3 *. | 1-6 | |
| A | | 11 | |
| A | FR-A-2 209 108  (GRAFFIN) * Page 5, ligne 11 - page 6, ligne 24; figure 1 * | 1-5,7 | |
| A | US-A-4 186 339  (FINGER) * Colonne 1, lignes 8-29; colonne 2, lignes 4-9,15-28; figures 1,3 * | 1,9 | |
| A | NEW ELECTRONICS, vol. 21, no. 6, juin 1988, pages 41-42, London, GB; D. KING: "Constant check for vehicle lights" * Page 41, colonne de gauche, alinéa 1; figure 1 * | 10 | DOMAINES TECHNIQUES RECHERCHES (Int. Cl.5) G 01 R |

Le présent rapport a été établi pour toutes les revendications

| Lieu de la recherche | Date d'achèvement de la recherche | Examinateur |
|---|---|---|
| LA HAYE | 13-09-1990 | SINAPIUS G.H. |